# EUROPEAN PATENT APPLICATION

(11) **EP 4 401 119 A1**
(43) Date of publication of application: **17.07.2024**
(21) Application number: 22866106.2
(22) Date of filing: 28.04.2022
(51) Int. Cl.: H01L 21/768, H01L 21/311, H01L 21/336, H01L 29/78

(54) **FORMING METHOD FOR FLOATING CONTACT HOLE, AND SEMICONDUCTOR DEVICE**

(30) Priority: 09.09.2021 CN 202111056393
(71) Applicant: CSMC Technologies Fab2 Co., Ltd., Wuxi, Jiangsu 214028 (CN)
(72) Inventor: LIU, Qun, Wuxi New District, Jiangsu 214028 (CN); ZHANG, Song, Wuxi New District, Jiangsu 214028 (CN); ZHOU, Yaohui, Wuxi New District, Jiangsu 214028 (CN); WANG, Dejin, Wuxi New District, Jiangsu 214028 (CN); ZHU, Wenming, Wuxi New District, Jiangsu 214028 (CN)
(74) Representative: Michalski Hüttermann & Partner Patentanwälte mbB
(86) International application number: PCT/CN2022/089808
(87) International publication number: WO 2023/035628

(57) **Abstract**

A forming method for a floating contact hole, and a semiconductor device. The method comprises: obtaining a substrate, and forming a tunnel oxide layer and a plurality of gates on the substrate; forming a metal silicide barrier layer; forming a self-aligned metal silicide; forming an interlayer dielectric layer; performing photoetching on the interlayer dielectric layer to obtain a photoresist pattern, the photoresist pattern comprising a small adhesive strip in the middle of the floating contact hole; and etching the floating contact hole by using the photoresist pattern as an etching mask layer.

## Description

### CROSS-REFERENCE TO RELATED APPLICATIONS

The present application claims priority to Chinese patent application No. 2021110563934, entitled "Method for forming floating contact and semiconductor device", filed on September 9, 2021, the content of which is hereby incorporated by reference in its entirety.

### TECHNICAL FIELD

The present application relates to the field of semiconductor manufacturing, in particular, to a method for forming a floating contact, and also a semiconductor device.

### BACKGROUND

The description in this section provides only background information relevant to the present application and do not necessarily constitute the prior art.

A floating contact (hereinafter referred to as floating CT for short) can achieve a reduced surface electric field (RESURF) effect and is an important means to improve device performance. In order to achieve the RESURF effect, a size of the floating CT is required to be generally 30% to 40% of a length of a drift area. Floating CT is actually a relatively large deep trench, and during etching, an etching rate for forming the floating CT is much faster than that for forming ordinary small holes. To ensure sufficient withstand voltage of the device, an oxide layer of sufficient thickness is required to be remained on the bottom of the floating CT. Therefore, in order to ensure sufficient process windows, it is necessary to greatly increase the thickness of the oxide layer of a salicide block (SAB, silicide area block) to ensure sufficient withstand voltage of the floating CT.

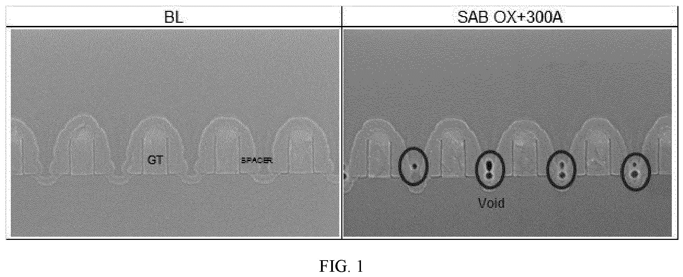

In order to improve the performance of integrated circuits and reduce the area of the integrated circuits, the integration of Bipolar-CMOS-DMOS (BCD) process with logic devices and memories is the future development focus. In order to achieve the maximum economic benefit, the line widths of the logic device and the memory are getting smaller and smaller, a spacing between polysilicon gates (GTs) of the logic device (or memory) is small, and the increase in the thickness of the oxide layer of the SAB can lead to voids appearing between polysilicon gates, as shown in FIG. 1. On the left side of FIG. 1, an electron microscope photograph of an exemplary (bit line, BL) device profile is shown, and on the right side of FIG. 1, an electron microscope photograph of a device profile in which the oxide layer of the SAB deposited during manufacture has a thickness 300 Å thicker than that on the left side (other conditions are the same as the device on left side) is shown. It can be seen that voids are formed at the positions framed by ellipses after the thickness of the oxide layer of the SAB has increased by 300 Å. These voids can affect the performance of the circuit and result in low yield. To ensure that the device has sufficient withstand voltage, the thickness of the oxide layer of the SAB needs to be increased, but thickening the oxide layer of the SAB may cause the problem of voids and affects the electrical performance of the device.

### SUMMARY

According to embodiments of the present application, a method for forming a floating contact and a semiconductor device are provided.

The method for forming a floating contact, includes: obtaining a substrate having a tunnel oxide and a plurality of gates formed thereon; depositing, photolithographing, and etching a salicide block to form the salicide block on the tunnel oxide, on the plurality of gates, and between adjacent gates; forming a self-aligned silicide at a portion where the salicide block is not formed; forming an interlayer dielectric layer on the plurality of gates, on the salicide block and on the self-aligned silicide; coating a photoresist on the interlayer dielectric layer, exposing the photoresist through a contact hole photomask, and followed by developing to obtain a photoresist pattern, the contact hole photomask including a floating contact pattern, the floating contact pattern including a photoresist retention region having a light transmittance opposite to that of a remaining region of the floating contact pattern, removing a photoresist pattern corresponding to a exposure of the remaining region during developing, and partially removing a photoresist pattern corresponding to a exposure of the photoresist retention region during developing by controlling a exposure condition during exposure; and etching the interlayer dielectric layer and the salicide block by taking the photoresist pattern as an etching mask layer to obtain the floating contact.

A semiconductor device in which a floating contact is formed by the method for forming the floating contact as described in any of the above embodiments. The semiconductor device further includes a conductive material filled in the floating contact. The salicide block includes a first oxide layer having a thickness in a range from 400 Å to 600 Å.

The details of one or more embodiments of the present application are provided in the accompanying drawings and the description hereinafter, so that other features, objectives, and advantages of the present application are more apparent.

### BRIEF DESCRIPTION OF THE DRAWINGS

In order to better describe and illustrate the embodiments and/or examples of the present application, reference may be made to one or more of the accompanying drawings. The additional details or examples used to describe the drawings should not be construed as limiting the scope of any of the present application, the presently described embodiments and/or examples, and the presently understood best modes of the application.
FIG. 1 is an electron microscope photograph of voids appearing between adj acent gates after an oxide layer of the SAB is thickened.
FIG. 2 is a flowchart of a method for forming a floating contact according to an embodiment.
FIG. 3 is a schematic cross-sectional view of a semiconductor structure at a position corresponding to a floating contact after step S220 is completed.
FIG. 4 is a schematic cross-sectional view of a semiconductor structure at a position corresponding to a floating contact after step S240 is completed.
FIG. 5 is a schematic cross-sectional view of a semiconductor structure at a position corresponding to a floating contact after step S250 is completed.
FIG. 6 is a schematic cross-sectional view of a semiconductor structure at a position corresponding to a floating contact after step S260 is completed.
FIG. 7 is a flow diagram of sub-steps of step S210 according to an embodiment.
FIG. 8 is a flow diagram of device manufacturing steps following step S260 according to an embodiment.

### DETAILED DESCRIPTION

In order to facilitate the understanding of the present application, a more comprehensive description of the present application will be provided below with reference to the relevant drawings. Preferred embodiments of the present application are set forth in the accompanying drawings. However, the present application may be implemented in many different forms and is not limited to the embodiments described herein. Rather, these embodiments are provided for the purpose of making the present application more thorough and comprehensive.

Unless otherwise defined, all technical and scientific terms used herein have the same meanings as those commonly understood by those skilled in the art of the present application. The terms used in the description of the present application herein are only for the purpose of describing specific embodiments and are not intended to limit the present application. The term "and/or" used herein includes any and all combinations of one or more associated listed items.

It should be understood that when an element or layer is referred to as "on", "adjacent to", "connected to", or "coupled to" other elements or layers, it may be directly on, adjacent to, connected to, or coupled to other elements or layers, or there may be an intermediate element(s) or a layer(s). Conversely, when an element is referred to as "directly on", "directly adjacent to", "directly connected to", or "directly coupled to" other elements or layers, there is no intermediate element or layer. It should be understood that although the terms "first", "second", "third", etc. may be used to describe various elements, components, regions, layers and/or portions, these elements, components, regions, layers and/or portions should not be limited by these terms. These terms are used only to distinguish one element, component, region, layer, or portion from another element, component, region, layer, or portion. Accordingly, without departing from the teachings of the present application, a first element, component, region, layer, or portion discussed below may be represented as a second element, component, region, layer, or portion.

Spatial relationship terms such as "under", "underneath", "beneath", "below", "above", "over", etc., may be used herein for convenience of description to describe the relationship of one element or feature shown in the figures with other elements or features. It should be understood that, in addition to the orientation shown in the figures, the spatial relationship terms are intended to include different orientations of devices in use and operation. For example, if the devices in the drawings are inverted, then the elements or features described as "underneath", "under" or "below" other elements will be oriented "above" other elements or features. Thus, the exemplary terms "underneath" and "under" may include both upper and lower orientations. The device may be differently oriented (rotated 90 degrees or oriented in other ways) and the spatial descriptors used herein are explained accordingly.

The terms used herein are intended to describe specific embodiments only and are not to be construed as limiting the present application. As used herein, the singular forms "an", "one" and "the/this" are also intended to include plural forms unless the context clearly indicates otherwise. It should also be understood that the terms "consist of" and/or "include", when used in this specification, determine the presence of such features, integers, steps, operations, elements and/or components, but do not exclude the presence or addition of one or more other features, integers, steps, operations, elements, components, and/or groups. When used herein, the term "and/or" includes any and all combinations of associated listed items.

Embodiments of the present application are described herein with reference to cross-sectional views that serve as schematic diagrams of ideal embodiments (and intermediate structures) of the present application. In this way, changes from the illustrated shape due to, for example, manufacturing techniques and/or tolerances can be anticipated. Accordingly, embodiments of the present application should not be limited to the particular shape of the regions shown herein, but rather include shape deviations caused by, for example, manufacturing. Accordingly, the regions shown in the figures are substantially schematic, and their shapes are not intended to show the actual shapes of the regions of the device and are not intended to limit the scope of the present application.

As described in the Background, an increase in the thickness of the oxide layer of the salicide block (SAB) results in voids appearing between the polysilicon gates. The reason is that when the oxide layer of the SAB is thickened, in order to completely remove the SAB at the position where the self-aligned silicide (salicide) needs to be formed, the amount of silicon substrate loss at the bottom of an area between polysilicon gates due to overetching may increase as the oxide layer of the SAB is thickened, so the ratio of depth to width of empty trenches between the polysilicon gates may increase after the etching of the SAB is completed. During a subsequent deposition of interlayer dielectric (ILD), it would be difficult to fully fill the empty trenches having high ratio of depth to width, resulting in the formation of voids.

Illustratively, for a Bipolar-CMOS-DMOS (BCD) process, void formation may be avoided by incorporating logic devices and/or memories with larger line widths while ensuring sufficient withstand voltage of the BCD device (by increasing the thickness of the deposited oxide layer of the SAB). However, the integration of logic devices and/or memories with larger line widths in the BCD can lead to increased chip area, which would increase chip cost, and affect economic benefits.

In the present application, by changing the design of the floating contacts, the deposited oxide layer of the SAB can ensure sufficient withstand voltage without being very thick, and thus preventing the formation of the void, so that the logic devices and/or memories with smaller line widths can be integrated, the chip area can be reduced, the chip cost can be lowered, and the economic benefits can be improved.

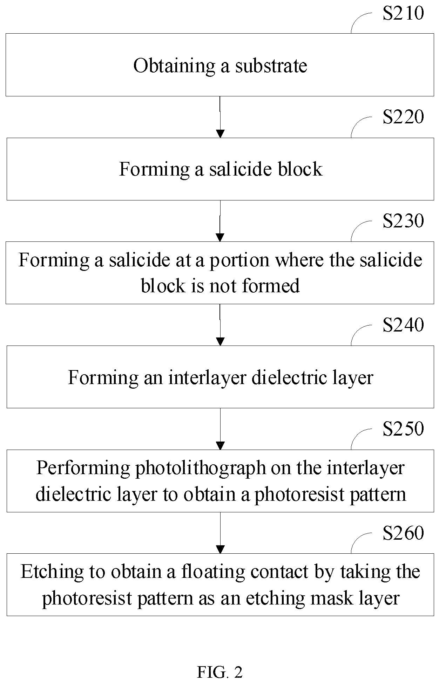

FIG. 2 is a flowchart of a method for forming a floating contact according to an embodiment, which includes the following steps.

At step S210, a substrate is obtained.

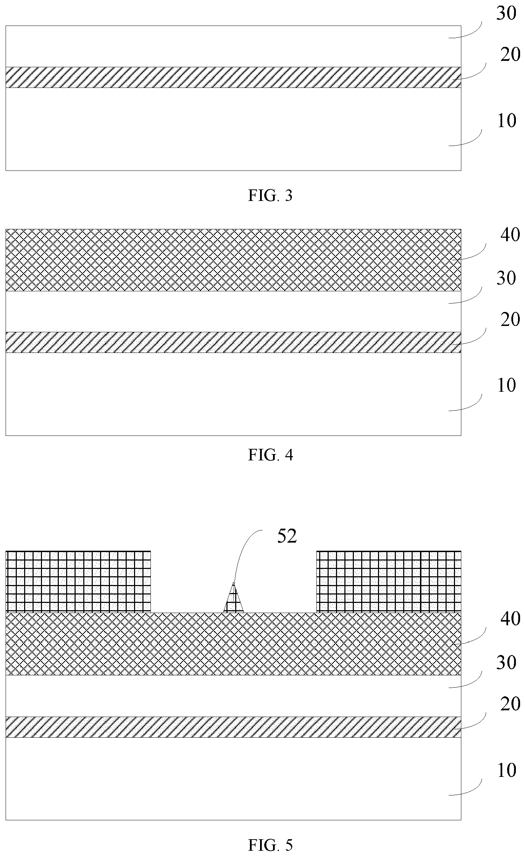

A tunnel oxide20 and a plurality of gates are formed on the substrate 10. In an embodiment of the present application, the substrate 10 is a semiconductor substrate, which may be made of undoped monocrystalline silicon, monocrystalline silicon doped with impurities, silicon-on-insulator (SOI), strained silicon-on-insulator (SSOI), strained SiGe-on-insulator (S-SiGeOI), SiGe-on-insulator (SiGeOI), and germanium-on-insulator (GeOI) or the like, and may also be made of at least one selected from the group consisting of Si, Ge, SiGe, SiC, SiGeC, InAs, GaAs, InP or other III/V compound semiconductors. In the embodiment shown in FIG. 3, the substrate 10 is formed of monocrystalline silicon. Devices such as N-Metal-Oxide-Semiconductor (NMOS) and/or P-Metal-Oxide-Semiconductor (PMOS) transistors, can be formed on the substrate 10. Likewise, a conductive member may be formed in the substrate 10, which may be a source or a drain of a transistor, a metal stack structure electrically connected to the transistor, or the like. In addition, an isolation structure such as a shallow trench isolation (STI) structure may also be formed on the substrate 10. In an embodiment of the present application, the tunnel oxide 20 may be made of a silicon oxide, such as silicon dioxide.

In an embodiment of the present application, the gate includes a gate dielectric layer and a gate layer on the gate dielectric layer. The gate dielectric layer may contain a conventional dielectric material such as silicon oxides, silicon nitrides, and silicon nitrogen oxides, having a dielectric constant ranging from about 4 to about 20 (measured in vacuum). Alternatively, the gate dielectric layer may contain a dielectric material having a generally higher dielectric constant ranging from about 20 to at least about 100. Such dielectric material having a higher dielectric constant may include, but is not limited to, hafnium oxide, hafnium silicate, titanium oxide, barium strontium titanate (BSTs), and plumbum zirconate titanate (PZTs). In an embodiment of the present application, the gate dielectric layer is a gate oxide layer made of silicon dioxide. In an embodiment of the present application, the gate layer is formed of a polysilicon material, and in other embodiments, metals, metal nitrides, metal silicides, or similar compounds may be used as materials used to make the gate layer.

In an embodiment of the present application, the method for forming the floating contact is applied to the BCD process.

In an embodiment of the present application, the gate is a gate of the logic device and/or memory.

In an embodiment of the present application, a spacer is also formed on both sides of the gate. The spacers may be made of one selected from the group consisting of silicon oxide, silicon nitride, and silicon nitride or any combination thereof.

At S220, a salicide block is formed.

The self-aligned silicide (salicide) refers to a very simple and convenient process of contact metallization, and in the manufacture of semiconductor devices, there are some regions that require a salicide process, while some other regions require a non-salicide process. For devices that require the non-salicide process, it is necessary to utilize the above salicide characteristics to enable the regions that require the non-salicide process to be covered with materials that do not react with metals. Such material used to cover non-salicide devices is called SAB.

In an embodiment of the present application, the SAB is deposited on the semiconductor structure obtained in step S210, and then photolithographed and etched to form a salicide block 30 on the tunnel oxide 20, on the gates, and between adjacent gates. FIG. 3 is a schematic cross-sectional view of a semiconductor structure at a position corresponding to the floating contact after the step S220 is completed. In the embodiment shown in FIG. 3, no gates are arranged at the position of the floating contact, so no gates are shown in FIG. 3.

In an embodiment of the present application, the salicide block 30 includes an oxide layer, such as a layer of silicon dioxide. Further, the salicide block 30 may also have a multilayer structure, for example, including an oxide layer and a nitride layer above the oxide layer. In an embodiment of the present application, the nitride layer is a layer of silicon nitride. In an embodiment of the present application, the oxide layer of the salicide block 30 has a thickness in a range from 400 Å to 600 Å.

At S230, a salicide is formed at a portion where the salicide block is not formed.

In an embodiment of the present application, the salicide may be made of one selected from the group consisting of CoSiₓ, NiSiₓ, PtSiₓ, or any combination thereof.

At S240, an interlayer dielectric layer is formed.

In an embodiment of the present application, the interlayer dielectric layer 40 is deposited on the semiconductor structure obtained in step S230.

The interlayer dielectric (ILD) layer may be a layer of silicon oxide, such as a material layer of doped or undoped silicon oxide formed using a thermal chemical vapor deposition (thermal CVD) manufacturing process or a high-density plasma chemical vapor deposition (HDPCVD) manufacturing process, and which specifically can be undoped silicate glass (USG), phosphosilicate glass (PSG) or boro-phospho-silicate glass glass (BPSG). In addition, the interlayer dielectric may also be boron-doped or phosphorus-doped spin-on-glass (SOG), phosphorus-doped tetraethoxysilane (PTEOS) or boron-doped tetraethoxysilane (BTEOS). In an embodiment of the present application, a layer of silicon nitride may be deposited prior to deposition of the ILD.

At step S250, a photoresist pattern is obtained by performing photolithograph on the interlayer dielectric layer.

A photoresist is coated on the interlayer dielectric layer 40, and exposed through a contact hole photomask. Then the exposed photoresist is developed. According to a pattern of the contact hole photomask, part of the photoresist is dissolved by a developing solution to form the photoresist pattern. The contact hole photomask includes a floating contact pattern.

In an embodiment of the present application, the floating contact pattern includes a photoresist retention region located in the middle of the floating contact pattern. The light transmittance of the photoresist retention region is opposite to that of the remaining region of the floating contact pattern (i.e., the photoresist retention region being opaque while the remaining region being transparent, or the photoresist retention region being transparent while the rest being opaque). Due to the arrangement of the photoresist retention region, the floating contact pattern on the contact hole photomask is not a large trench pattern, but is divided into two small trench patterns by the photoresist retention region. A photoresist region of the floating contact pattern corresponding to an exposure of regions other than the photoresist retention region, is dissolved by the developing solution during development, while a portion of a photoresist region corresponding to an exposure of the photoresist retention region is dissolved by the developing solution during development, forming a photoresist strip 52, referring to FIG. 5. In the embodiment shown in FIG. 5, the photoresist strip 52 is located in the middle of the portion of the photoresist region that is dissolved by the developing solution. Partially dissolving the photoresist region corresponding to the exposure of the photoresist retention region is achieved by controlling the exposure conditions during exposure. In an embodiment of the present application, the photoresist is a positive photoresist, the photoresist retention region is an opaque region, and the remaining region of the floating contact pattern is a transparent region. The exposure energy during exposure is increased (i.e., an exposure energy greater than the normal exposure energy is used) to overexpose the photoresist, such that the photoresist region corresponding to the exposure of the photoresist retention region is also partially dissolved during development, thereby forming the photoresist strip 52 having a thickness less than that of the photoresist remained after development.

In another embodiment of the present application, the photoresist can also be a negative photoresist. The photoresist retention region is a transparent region, and the remaining region of the floating contact pattern is an opaque region. The exposure energy is decreased during exposure (i.e., an exposure energy less than the normal exposure energy is used) to perform exposure such that the photoresist is underexposed.

At step S260, a floating contact is obtained through etching by taking the photoresist pattern as an etching mask layer.

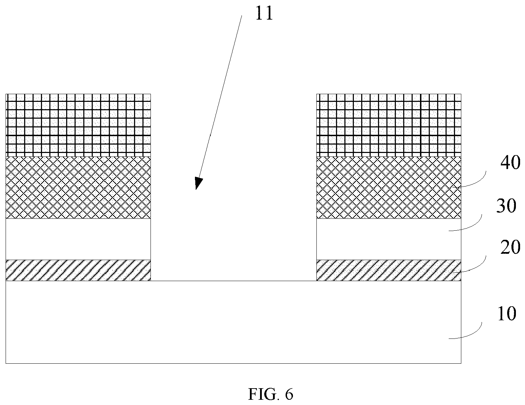

Referring to FIG. 6, the interlayer dielectric layer 40 and the salicide block 30 are etched by taking the photoresist pattern obtained after photolithographing in step S250 as the etching mask layer to obtain the floating contact 11. The photoresist strip 52 can slow down the etching rate during the etching to form the floating contact. Meanwhile, the photoresist strip 52 (the positive resist) has a relatively small thickness due to overexposure and is consumed up during the etching to form the floating contact, so that a stable floating contact profile can still be obtained.

For embodiments in which the photoresist is a negative resist, the photoresist strip 52 has a relatively small thickness due to underexposure and is also consumed up during the etching to form the floating contact, so that a stable floating contact profile can still be obtained.

In the method for forming a floating contact, the floating contact pattern is provided with the photoresist retention region having light transmittance opposite to that of the remaining region. The photoresist corresponding to the exposure of the photoresist retention region is partially removed during the development by controlling the exposure conditions, so as to obtain the photoresist strip having the thickness smaller than that of the remained photoresist, so that the etching rate is slowed down by this small photoresist strip when performing etching to form the floating contact. Meanwhile, this small photoresist strip would be consumed up during the etching to form the floating contact, so that the stable floating contact profile can still be obtained. Since the etching rate when forming the floating contact is slowed down by the small photoresist strip, the salicide block does not need to be thickened, and the oxide layer at the bottom of the floating contact can be ensured to have sufficient thickness, so as to ensure sufficient withstand voltage of the device. Meanwhile, the salicide block with small thickness is beneficial to avoid the formation of voids between adjacent gates of the logic device (or memory) with small line width. As a result, the logic device and/or the memory with smaller line width can be integrated in the chip, thereby reducing the chip area, reducing the chip cost, and improving the economic benefit.

In an embodiment of the present application, the floating contact 11 is filled with a conductive medium as a hole-field plate, which can improve the surface electric field of the drift area (i.e., RESURF). Accordingly, step S260 is followed by a step of filling the floating contact 11 with the conductive medium.

In the embodiment shown in FIG. 5, the floating contact pattern is divided into two small trench patterns by the photoresist retention region. In other embodiments, the floating contact pattern may also be provided with two or more photoresist retention regions, and for example, the floating contact pattern can be divided into three small trench patterns by two photoresist retention regions.

In an embodiment of the present application, on the contact hole photomask, a width of the photoresist retention region accounts for 30% to 40% of a width of the entire floating contact pattern.

In an embodiment of the present application, the floating contact 11 is formed above a drift area of a laterally diffused metal oxide semiconductor (LDMOS) field effect transistor. In another embodiment of the present application, a portion of the structure of the floating contact 11 may extend beyond the drift area in the width direction, for example, a portion of the floating contact 11 is positioned above the drift area, and another portion of the floating contact 11 is positioned above the gate structure. At least a portion of the floating contact being positioned above the drift area, can also improve the surface electric field of the drift area.

In an embodiment of the present application, the width of the floating contact 11 is in a range from 30% to 40% of the length of the drift area of the LDMOS. The width direction of the floating contact 11 refers to the length direction of the drift area, i.e., the transverse direction in FIG. 6.

In an embodiment of the present application, the tunnel oxide 20 has a thickness in a range from 1000 Å to 1200 Å.

In an embodiment of the present application, the etching in step S260 is adopted as dry etching. In an embodiment of the present application, the etching gas for dry etching includes C₄F₈ and O₂.

In an embodiment of the present application, during etching the salicide block at step S260, an end point detection is adopted, that is, the material at the bottom of the etched hole is monitored during etching. The etching is stopped when the material of the expected etching stop layer is detected.

In an embodiment of the present application, step S240 further includes a step of planarizing the interlayer dielectric layer 40 after depositing the ILD. In particular, the interlayer dielectric layer 40 may be planarized by chemical mechanical polishing (CMP).

In an embodiment of the present application, there may be other contact hole patterns on the contact hole photomask in addition to the floating contact pattern. Accordingly, when photolithographing in step S250, the photoresist corresponding to the positions of other contact holes will also be patterned, thereby forming the other contact holes during the etching in step S260.

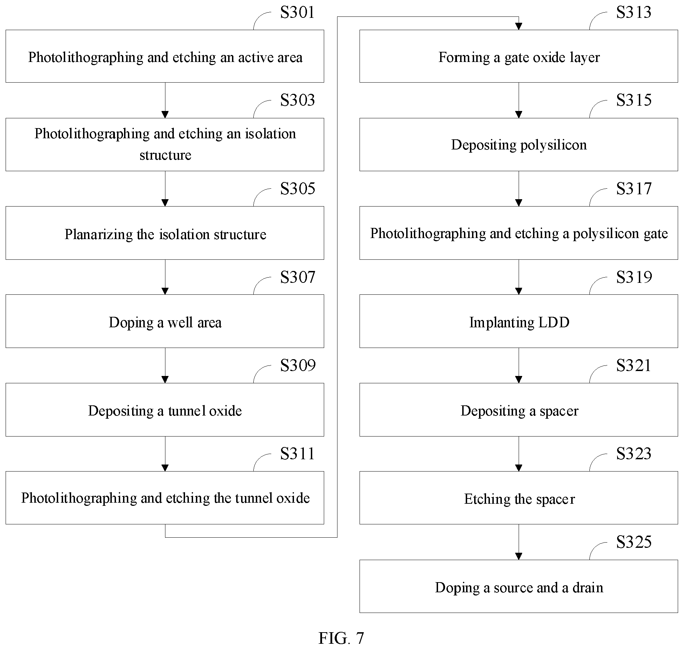

Referring to FIG. 7, in an embodiment of the present application, step S210 includes the following steps.

At step S301, an active area is photolithographed and etched.

The active area is photolithographed and etched on the substrate.

At step S303, an isolation structure is photolithographed and etched.

In an embodiment of the present application, the isolation structure is a shallow trench isolation (STI).

At step S305, the isolation structure is planarized.

In an embodiment of the present application, the STI is planarized by chemical mechanical polishing (CMP).

At step S307, a well area is doped.

In an embodiment of the present application, ion implantation into the substrate is performed to form the well area.

At step S309, the tunnel oxide is deposited.

The tunnel oxide is deposited on the semiconductor structure obtained in step S307.

At step S311, the tunnel oxide is photolithographed and etched.

The tunnel oxide is used to improve the withstand voltage of the LDMOS, and the tunnel oxide at the positions where the tunnel oxide is not required is etched and removed.

At step S313, a gate oxide layer is formed.

The gate oxide layer can be formed by means of growing or depositing an oxide layer by thermal oxidation.

At step S315, polysilicon is deposited.

The polysilicon is deposited on the semiconductor structure obtained in step S315.

At step S317, a polysilicon gate is photolithographed and etched.

A plurality of polysilicon gates is formed by performing photolithograph and etching.

At step S319, a lightly doped drain is implanted.

The semiconductor structure obtained in step S317 is implanted with the lightly doped drain (LDD).

At step S321, a spacer is deposited.

The material used to form the spacer is deposited on the semiconductor structure obtained in step S319.

At step S323, the spacer is etched.

The material used to form the spacer is etched to form the spacer on both sides of each gate.

At step S325, a source and a drain are doped.

N-type source/drain (NSD) doping and P-type source/drain (PSD) doping are performed.

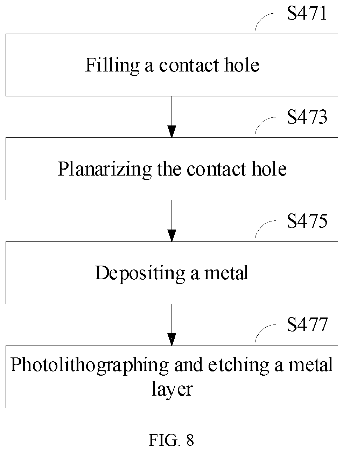

Referring to FIG. 8, in an embodiment of the present application, the following steps are included after the step S210.

At step S471, the contact holes are filled.

A conductive material is deposited to fill the contact holes (including the floating contacts). The conductive material may be any suitable conductive material for contact holes well known to those skilled in the art, including but not limited to metal materials, where the metal materials may include one or more of Ag, Au, Cu, Pd, Pt, Cr, Mo, Ti, Ta, W and Al. In an embodiment of the present application, the filled conductive material includes tungsten.

At step S473, the contact holes are planarized.

The conductive material deposited in step S471 is planarized, and specifically by CMP.

S475, a metal is deposited.

The metal is deposited on the semiconductor structure obtained in step S473. The metal material may include aluminum.

At step S477, a metal layer is photolithographed and etched.

The metal deposited in the step S475 is photolithographed and etched to obtain metal stacks. At least a part of the metal stacks are electrically connected to tungsten plugs filled in a part of the contact holes.

The present application accordingly provides a semiconductor device, in which a floating contact is formed by the method for forming a floating contact as described in any of the above embodiments, with the floating contact being filled with the conductive material (such as a tungsten plug). The salicide block of the semiconductor device includes an oxide layer having a thickness in a range from 400 Å and 600 Å. In an embodiment of the present application, the semiconductor device includes an LDMOS, and a floating contact is disposed above a drift area of the LDMOS. In an embodiment of the present application, the width of the floating contact is in a range from 30% to 40% of the length of the drift area of the LDMOS. In an embodiment of the present application, the tunnel oxide at the bottom of the floating contact has a thickness in a range from 1000 Å to 1200 Å.

It is to be understood that although the various steps in the flowcharts of the application are displayed in sequence as indicated by the arrows, these steps are not necessarily performed in sequence in the order indicated by the arrows. Unless expressly stated herein, the execution of these steps is not strictly restricted and may be performed in other order. Moreover, at least a part of the steps in the flowcharts of this application may include a plurality of steps or a plurality of stages, which are not necessarily performed at the same time, but may be executed at different times, and the order of execution of these steps or stages is not necessarily performed sequentially, but may be performed in turn or alternately with other steps or at least a part of the steps or stages of other steps.

In the description of the present application, the description of the terms "some embodiments", "other embodiments", "preferred embodiments", and the like, means that specific features, structures, materials or characteristics described in combination with the embodiment or example are included in at least one embodiment or example of the embodiments of this application. In the description, the illustrative description of the above terms does not necessarily refer to the same embodiment or example.

The technical features of the embodiments above may be combined arbitrarily. To make the description concise, not all possible combinations of the technical features in the above embodiments are described. However, as long as there are no contradictions in the combinations of these technical features, all of the combinations should be considered to be within the scope of the specification.

The embodiments above only represent several implementation modes of the present application, and the description thereof is relatively specific and detailed, but it should not be construed as limiting the scope of the patent. It should be noted that for those skilled in the art, various modifications and improvements may be made without departing from the concept of the present application, and all these modifications and improvements belong to the protection scope of the present application. Therefore, the scope of protection of the patent application should be subject to the appended claims.

## Claims

1. A method for forming a floating contact, comprising:
obtaining a substrate having a tunnel oxide and a plurality of gates formed thereon;
depositing, photolithographing, and etching a salicide block to form the salicide block on the tunnel oxide, on the plurality of gates, and between adjacent gates;
forming a self-aligned silicide at a portion where the salicide block is not formed;
forming an interlayer dielectric layer on the plurality of gates, on the salicide block and on the self-aligned silicide;
coating a photoresist on the interlayer dielectric layer, exposing the photoresist through a contact hole photomask, and followed by developing to obtain a photoresist pattern, the contact hole photomask comprising a floating contact pattern, the floating contact pattern comprising a photoresist retention region having a light transmittance opposite to that of a remaining region of the floating contact pattern, and removing a photoresist pattern corresponding to a exposure of the remaining region during developing, and partially removing a photoresist pattern corresponding to a exposure of the photoresist retention region during developing by controlling a exposure condition during exposure; and
etching the interlayer dielectric layer and the salicide block by taking the photoresist pattern as an etching mask layer to obtain the floating contact.

2. The method according to claim 1, wherein the photoresist is a positive photoresist, the photoresist retention region is an opaque region, and the remaining region is a transparent region; and
the partially removing the photoresist pattern corresponding to the exposure of the photoresist retention region during developing by controlling the exposure condition comprises overexposing the photoresist.

3. The method according to claim 1, wherein a width of the photoresist retention region accounts for 30% to 40% of a width of the entire floating contact pattern.

4. The method according to claim 1, wherein the floating contact is formed above a drift area of a laterally diffused metal oxide semiconductor field effect transistor.

5. The method according to claim 4, wherein a width of the floating contact is in a range from 30% to 40% of a length of the drift area, and a width direction of the floating contact is parallel to a length direction of the drift area.

6. The method according to claim 1, wherein in the forming the salicide block on the tunnel oxide, on the plurality of gates, and between adjacent gates, the formed salicide block comprises a first oxide layer having a thickness in a range from 400 Å to 600 Å.

7. The method according to claim 1, wherein in the obtaining the substrate, a thickness of the tunnel oxide formed on the substrate is in a range from 1000 Å to 1200 Å.

8. The method according to claim 1, wherein each of the plurality of gates comprises a gate oxide layer and a polysilicon gate on the gate oxide layer, and a spacer on both sides of each of the plurality of gates is formed on the substrate obtained in the obtaining the substrate.

9. The method according to claim 1, wherein the method is applied to a Bipolar-CMOS-DMOS (BCD) process.

10. The method according to claim 1, wherein the etching the interlayer dielectric layer and the salicide block by taking the photoresist pattern as the etching mask layer comprises dry etching, and an etching gas for the dry etching comprises C₄F₈ and O₂.

11. The method according to claim 1, wherein in the etching the interlayer dielectric layer and the salicide block by taking the photoresist pattern as the etching mask layer to obtain the floating contact, during etching the salicide block, an end point detection is adopted.

12. The method according to claim 1 further comprising: after the obtaining the floating contact, filling the floating contact with a conductive material.

13. The method according to claim 1, wherein in the partially removing the photoresist pattern corresponding to the exposure of the photoresist retention region during developing by controlling the exposure condition during exposure, a portion of a photoresist region corresponding to the exposure of the photoresist retention region is dissolved by a developing solution during development, forming a photoresist strip located in a middle of the portion of the photoresist region that is dissolved by the developing solution.

14. The method according to claim 1, wherein each of the plurality of gates is a gate of a logic device and/or a memory.

15. A semiconductor device, in which a floating contact is formed by:
obtaining a substrate having a tunnel oxide and a plurality of gates formed thereon;
depositing, photolithographing, and etching a salicide block to form the salicide block on the tunnel oxide, on the plurality of gates, and between adjacent gates;
forming a self-aligned silicide at a portion where the salicide block is not formed;
forming an interlayer dielectric layer on the plurality of gates, on the salicide block and on the self-aligned silicide;
coating a photoresist on the interlayer dielectric layer, exposing the photoresist through a contact hole photomask, and followed by developing to obtain a photoresist pattern, the contact hole photomask comprising a floating contact pattern, the floating contact pattern comprising a photoresist retention region having a light transmittance opposite to that of a remaining region of the floating contact pattern, and removing a photoresist pattern corresponding to a exposure of the remaining region during developing, and partially removing a photoresist pattern corresponding to a exposure of the photoresist retention region during developing by controlling a exposure condition during exposure; and
etching the interlayer dielectric layer and the salicide block by taking the photoresist pattern as an etching mask layer to obtain the floating contact,
wherein the semiconductor device further comprising a conductive material filled in the floating contact, and the salicide block comprises a first oxide layer having a thickness in a range from 400 Å to 600 Å.
